# EUROPÄISCHE PATENTANMELDUNG

(11) **EP 4 607 799 A1**
(43) Veröffentlichungstag der Anmeldung: **27.08.2025**
(21) Anmeldenummer: 25158681.4
(22) Anmeldetag: 18.02.2025
(51) Int. Cl.: H03K 17/687, H03K 17/18

(54) **SICHERHEITSSCHALTGERÄT ZUR FEHLERSICHEREN ABSCHALTUNG EINES EXTERNEN VERBRAUCHERS**

(30) Priorität: 22.02.2024 DE 102024105070
(71) Anmelder: Pilz GmbH & Co. KG, 73760 Ostfildern (DE)
(72) Erfinder: Zinser, Christoph, 73760 Ostfildern (DE)
(74) Vertreter: Witte, Weller & Partner Patentanwälte mbB

(57) **Zusammenfassung**

Sicherheitsschaltgerät (10) zur fehlersicheren Abschaltung eines externen Verbrauchers (40), aufweisend: einen ersten Anschluss (24) zum Aufnehmen eines ersten Potentials; einen zweiten Anschluss (26) zum Aufnehmen eines zweiten Potentials; einen dritten Anschluss (28) zum Ausgeben des ersten Potentials an den externen Verbraucher (40); einen vierten Anschluss (30) zum Ausgeben des zweiten Potentials an den externen Verbraucher (40); einen ersten schaltbaren Leitungspfad (32) zwischen dem ersten Anschluss (24) und dem dritten Anschluss (28), der in einem eingeschalteten Zustand das erste Potential mit dem dritten Anschluss (28) verbindet; einen zweiten schaltbaren Leitungspfad (34) zwischen dem zweiten Anschluss (26) und dem vierten Anschluss (30), der in einem eingeschalteten Zustand das zweite Potential mit dem vierten Anschluss (30) verbindet; einen ersten Rücklesekoppler, über den ein an dem dritten Anschluss (28) anliegendes erstes Rücklesepotential erfassbar ist; einen zweiten Rücklesekoppler, über den ein an dem vierten Anschluss (30) anliegendes zweites Rücklesepotential erfassbar ist; einen durch den ersten Rücklesekoppler gebildeten dritten Leitungspfad (48) zwischen dem zweiten Anschluss (26) und dem dritten Anschluss (28); sowie einen vierten Leitungspfad (52) zwischen dem ersten Anschluss (24) und dem vierten Anschluss (30), der mit dem zweiten Rücklesekoppler verbunden ist. Ferner weist der vierte Leitungspfad (52) eine Abschalteinrichtung (54) auf, über die der vierte Leitungspfad (52) zwischen einem leitenden Zustand und einem nicht leitenden Zustand umschaltbar ist.

## Beschreibung

Die vorliegende Erfindung betrifft ein Sicherheitsschaltgerät zur fehlersicheren Abschaltung eines externen Verbrauchers.

Sicherheitsschaltgeräte, auch Sicherheitsschaltvorrichtungen genannt, sind der Ursprung und das Rückgrat der sicheren Automatisierungstechnik. Als eigenständige Geräte überwachen Sicherheitsschaltgeräte Sicherheitsfunktionen wie Not-Aus, Schutztüren, Lichtschranken, Lichtgitter, Schaltmatten und viele mehr. Sicherheitsschaltgeräte führen somit definierte Sicherheitsfunktionen aus und sorgen z. B. für ein kontrolliertes und damit sicheres Stillsetzen einer Bewegung, die Stellungsüberwachung von beweglichen trennenden Schutzeinrichtungen und die Unterbrechung einer Schließbewegung bei einem Eingriff. Sicherheitsschaltgeräte dienen insbesondere der Risikominderung und leiten im Fehlerfall und bei Verletzung von Schutzzonen eine sichere und zuverlässige Reaktion ein. Sicherheitsschaltgeräte sind in nahezu allen Bereichen des Maschinen- und Anlagenbaus anzutreffen, vorrangig dort, wo die Anzahl der Sicherheitsfunktionen überschaubar ist.

Sicherheitsschaltgeräte verfügen über mindestens einen Eingang und einen schaltbaren Ausgang. Über den Eingang werden dem Sicherheitsschaltgerät Eingangssignale von Sicherheitsgebern, wie z. B. Not-Aus-Tastern, Lichtschranken usw., zugeführt, die einen Zustand des Sicherheitsgebers und damit einer technischen Anlage repräsentieren. In Abhängigkeit von den Eingangssignalen kann der Ausgang des Sicherheitsschaltgerätes geschaltet werden. Liegt ein Eingangssignal an, das einen sicheren Zustand der technischen Anlage signalisiert, schaltet das Sicherheitsschaltgerät den Ausgang ein, sodass ein Sicherheitskreis geschlossen ist. Der geschlossene Sicherheitskreis erlaubt wiederum den Betrieb oder das Anfahren der technischen Anlage. Fehlt dagegen eines der Eingangssignale, so schaltet das Sicherheitsschaltgerät den Ausgang ab und unterbricht den Sicherheitskreis, wodurch in der Regel die technische Anlage abgeschaltet bzw. deren Anlauf verhindert wird. Alternativ kann die Unterbrechung des Sicherheitskreises auch zu einer anderen Reaktion der technischen Anlage führen, die einen sicheren Zustand herbeiführt.

Im Gegensatz zu einem normalen Schaltrelais darf bei einem Sicherheitsschaltgerät - bei richtiger Beschaltung - weder ein Fehler im Gerät selbst noch ein extern durch Sensor oder Aktor verursachter Fehler zum Verlust der Sicherheitsfunktion führen. Zu diesem Zweck verfügt ein Sicherheitsschaltgerät gegenüber einem normalen Schaltrelais über zusätzliche spezielle Schaltungen, Einrichtungen oder eine besondere Relaistechnik, um auch im Fehlerfall einen sicheren Schaltvorgang gewährleisten zu können.

Ein Beispiel für weitere Einrichtungen eines Sicherheitsschaltgerätes sind Rückleseeinrichtungen. Rückleseeinrichtungen können den aktuellen Schaltzustand eines Ausgangs erfassen und verifizieren. Mit anderen Worten: Durch Rücklesen der Ausgänge kann überprüft werden, ob ein Schaltvorgang wie gewünscht stattgefunden hat. Dies ist einerseits für eine Diagnosefähigkeit der Sicherheitseinrichtung relevant, kann aber auch direkt als Teil der eigentlichen Sicherheitseinrichtung dazu beitragen, die notwendige Sicherheit der eingesetzten Komponenten zu gewährleisten. Dies ermöglicht z. B. die Verwendung von Halbleiterschaltern zum Schalten der Ausgänge, deren sichere Verwendung nur durch das Rücklesen der Ausgänge gewährleistet werden kann.

Das Rücklesen eines Ausgangs kann durch die Messung einer Spannung in einem Leitungspfad zwischen dem betreffenden Ausgang und einem dem zu schaltenden Potential entgegengesetzten Potential erfolgen. Die Messung kann über einen Spannungsteiler oder einen Optokoppler im Leitungspfad, im Folgenden als Rücklesekoppler bezeichnet, erfolgen. Da bei einer solchen Messung jedoch ein Strom vom jeweiligen Ausgang zu dem Potential fließt, kann die Rücklesung unerwünschte Auswirkungen auf den jeweiligen Ausgang haben. Umgekehrt kann eine an den Ausgang angeschlossene Last die Rücklesespannung beeinflussen und zu einer fehlerhaften Rücklesung führen. Beispielsweise wird eine Rücklesespannung schwächer, je niederohmiger die angeschlossene Last ist. Außerdem können kapazitive Lasten im Einschaltmoment einen Kurzschluss verursachen, der eine Rücklesespannung ungültig macht.

Werden in einem Sicherheitsschaltgerät zwei Ausgänge kombiniert und zum Schalten von zwei Polen einer Last verwendet (zweipoliger Ausgang), so kann es bei Verwendung bekannter Rückleseeinrichtungen ferner dazu kommen, dass sich die Rückleseeinrichtungen gegenseitig stören und es zu fehlerhaften Rücklesungen (Pseudofehlern) kommt.

EP 3 465 720 A1 zeigt eine komplexe Rückleseeinrichtung für ein Sicherheitsschaltgerät mit zweipoligem Ausgang. Die Rückleseeinrichtung weist einen internen Verbraucher und einen zusätzlichen Schalter auf. Über den Schalter kann eine Testeinrichtung den internen Verbraucher parallel zu einer externen Last schalten und verschiedene Schalttests durchführen, indem die Testeinrichtung die Ausgänge ein- und ausschaltet und die jeweilige Reaktion auf die Schaltvorgänge an Rücklesepunkten ermittelt. Durch die verschiedenen Tests kann ein Fehler nicht nur erkannt, sondern auch spezifiziert werden. Die in EP 3 465 720 A1 gezeigte Rückleseschaltung ist komplex und auch hier hat die externe Last Einfluss auf die Rücklesung und die Rücklesung Einfluss auf die Ausgänge. Außerdem muss für bestimmte Schalttests einer der Ausgänge tatsächlich eingeschaltet werden, was ein gewisses Sicherheitsrisiko birgt.

Vor diesem Hintergrund ist es eine Aufgabe, ein Sicherheitsschaltgerät mit einer verbesserten Rückleseeinrichtung bereitzustellen, die eine einfache und rückwirkungsfreie Überwachung der Ausgänge des Sicherheitsschaltgerätes ermöglicht. Insbesondere ist eine Rückleseeinrichtung anzugeben, die bei einem Sicherheitsschaltgerät, das über zwei Ausgänge zwei Pole einer gemeinsamen Last schaltet, ein unabhängiges und rückwirkungsfreies Rücklesen der einzelnen Ausgänge ermöglicht.

Gemäß einem Aspekt der vorliegenden Offenbarung wird die Aufgabe gelöst durch ein Sicherheitsschaltgerät zur fehlersicheren Abschaltung eines externen Verbrauchers, aufweisend: einen ersten Anschluss zum Aufnehmen eines ersten Potentials; einen zweiten Anschluss zum Aufnehmen eines zweiten Potentials; einen dritten Anschluss zum Ausgeben des ersten Potentials an den externen Verbraucher; einen vierten Anschluss zum Ausgeben des zweiten Potentials an den externen Verbraucher; einen ersten schaltbaren Leitungspfad zwischen dem ersten Anschluss und dem dritten Anschluss, der in einem eingeschalteten Zustand das erste Potential mit dem dritten Anschluss verbindet; einen zweiten schaltbaren Leitungspfad zwischen dem zweiten Anschluss und dem vierten Anschluss, der in einem eingeschalteten Zustand das zweite Potential mit dem vierten Anschluss verbindet; einen ersten Rücklesekoppler, über den ein an dem dritten Anschluss anliegendes erstes Rücklesepotential erfassbar ist; einen zweiten Rücklesekoppler, über den ein an dem vierten Anschluss anliegendes zweites Rücklesepotential erfassbar ist; einen durch den ersten Rücklesekoppler gebildeten dritten Leitungspfad zwischen dem zweiten Anschluss und dem dritten Anschluss; sowie einen vierten Leitungspfad zwischen dem ersten Anschluss und dem vierten Anschluss, der mit dem zweiten Rücklesekoppler verbunden ist, wobei der vierte Leitungspfad eine Abschalteinrichtung aufweist, über die der vierte Leitungspfad zwischen einem leitenden Zustand und einem nichtleitenden Zustand umschaltbar ist.

Es ist somit eine Idee der vorliegenden Erfindung, die Rücklesepfade (dritter und vierter Leitungspfad) zweier schaltbarer Ausgänge (dritter und vierter Anschluss) eines Sicherheitsschaltgeräts in geeigneter Weise auszugestalten, um eine gegenseitige Beeinflussung der Rücklesepfade zu reduzieren bzw. auszuschließen. Dazu wird ein Rücklesepfad (vierter Leitungspfad) mit einer Abschalteinrichtung versehen, über die der Rücklesepfad abgeschaltet, d.h. aufgetrennt, werden kann. Durch die Abschaltbarkeit des Rücklesepfades ist eine Minimierung von Rücklesefehlern möglich, wodurch vorteilhaft eine höhere Zuverlässigkeit des Sicherheitsschaltgeräts und damit verbunden eine Erhöhung der Gesamtsicherheit erreicht werden kann.

Da nur geringe bauliche Veränderungen an den Rücklesepfaden vorgenommen werden müssen, können die Vorteile einfach und kostengünstig realisiert werden. Ebenso kann eine Testeinrichtung, die das korrekte Schalten der Potentiale an den Ausgängen sicherstellen soll und dazu die an den Ausgängen anliegenden Potentiale über die Rücklesekoppler erfasst, auf einfache Weise an die oben beschriebene Anordnung angepasst werden.

In einer weiteren Ausgestaltung kann der vierte Leitungspfad niederohmiger ausgebildet sein als der dritte Leistungspfad.

Diese Ausgestaltung trägt weiter zu einer Minimierung von Rücklesefehlern bei, da eine gegenseitige Beeinflussung der Leitungspfade bei der Rücklesung durch die unterschiedliche Ausgestaltung der Pfade vermindert werden kann.

In einer weiteren Ausgestaltung kann der erste Rücklesekoppler und/oder der zweite Rücklesekoppler ein Spannungsteiler sein.

Bei dieser Ausgestaltung ist mindestens einer der beiden Rücklesekoppler ein Spannungsteiler. Der Spannungsteiler kann zwei in Reihe geschaltete Widerstände aufweisen, die im jeweiligen Rücklesepfad angeordnet sind. Zwischen den Widerständen kann sich ein Rücklesepunkt befinden, über den das Rücklesepotential ermittelt werden kann. Der Gesamtwiderstand des Spannungsteilers trägt wesentlich zum Widerstand im Rücklesepfad bei. Durch geeignete Wahl der Widerstände kann das gewünschte Widerstandsverhältnis zwischen den beiden Rücklesepfaden auf einfache Weise eingestellt werden. Die Auslegung trägt somit zu einer kostengünstigen Realisierung der verbesserten Rücklesemöglichkeit bei.

In einer weiteren Ausgestaltung kann der erste Rücklesekoppler und/oder der zweite Rücklesekoppler ein Optokoppler sein.

Gemäß dieser Ausgestaltung ist mindestens einer der beiden Rücklesekoppler ein Optokoppler. Durch einen Optokoppler kann eine mit dem Rücklesekoppler verbundene Detektionsschaltung von dem jeweiligen Rücklesepfad galvanisch getrennt werden. Ein Übersprechen zwischen Rücklesepfad und Detektionsschaltung, z. B. aufgrund einer Überspannung in einem der Schaltungsteile, kann so verhindert werden. Außerdem kann das gewünschte Widerstandsverhältnis zwischen dem ersten Rücklesepfad und dem zweiten Rücklesepfad unabhängig von dem Rücklesekoppler eingestellt werden.

In einer weiteren Ausgestaltung kann das Sicherheitsschaltgerät ferner aufweisen: eine Testeinrichtung, die mit dem ersten Rücklesekoppler und dem zweiten Rücklesekoppler verbunden ist und dazu eingerichtet ist, über den ersten Rücklesekoppler das erste Rücklesepotential zu erfassen und über den zweiten Rücklesekoppler das zweite Rücklesepotential zu erfassen sowie anhand des ersten Rücklesepotentials einen Schaltzustand des ersten Leitungspfads zu bestimmen und anhand des zweiten Rücklesepotentials einen Schaltzustand des zweiten Leitungspfads zu bestimmen.

Diese Ausgestaltung ermöglicht es, in bekannter Weise eine Testeinrichtung zu verwenden, die Schalttests durchführt, um die Funktionsfähigkeit der Schaltelemente in den schaltbaren Leitungspfaden zu testen. Somit kann auf eine bekannte Testeinrichtung zurückgegriffen werden, die die verbesserten Rücklesemöglichkeiten nutzt und hierfür nicht wesentlich modifiziert werden muss. Die Auslegung trägt somit auch zu einer effektiven und kostengünstigen Realisierung des Sicherheitsschaltgerätes bei.

In einer weiteren Ausgestaltung kann die Abschalteinrichtung in dem vierten Leitungspfad von der Testeinrichtung angesteuert werden, um den vierten Leistungspfad leitend oder nicht leitend zu schalten.

Gemäß dieser Ausgestaltung kann die Testeinrichtung den vierten Leitungspfad aktiv ein- oder ausschalten. Diese Ausgestaltung hat den Vorteil, dass die Testeinrichtung selbst bestimmen kann, wann sie den Leitungspfad einschaltet und dementsprechend die Rücklesezeitpunkte wählen kann. Beispielsweise kann die Testeinrichtung den Schaltzustand des ersten Leitungspfades nur dann ermitteln, wenn sich der vierte Leitungspfad in dem nicht leitenden Zustand befindet, oder den Schaltzustand des zweiten Leitungspfades nur dann ermitteln, wenn sich der vierte Leitungspfad in dem leitenden Zustand befindet. Durch die aktive Steuerung der Ausschalteinrichtung durch die Testeinrichtung kann die Testeinrichtung eine zeitliche Steuerung der Ausschalttests und des Rücklesens selbst steuern.

In einer weiteren Ausgestaltung kann das Sicherheitsschaltgerät eine Spannungsstabilisierung aufweisen, die durch die Abschalteinrichtung schaltbar in dem vierten Leitungspfad angeordnet ist.

Durch die Spannungsstabilisierung in dem schaltbaren Rücklesepfad kann eine Rücklesung unabhängiger von den elektrischen Eigenschaften der angeschlossenen Last und den Höhen der zu schaltenden Potentiale gemacht werden. So können durch die Spannungsstabilisierung Schwankungen einer Rückleseschwelle vorteilhaft reduziert werden. Die Auslegung trägt direkt zur Verbesserung der Rücklesefähigkeit bei und kann insbesondere deren Zuverlässigkeit erhöhen.

Bei der Verwendung einer Spannungsstabilisierung in dem Rücklesepfad kann der zweite Rücklesekoppler als Optokoppler ausgebildet sein, der eine LED aufweist, die in dem Rücklesepfad angeordnet ist.

Bei dieser Ausgestaltung kann die LED eines als Rücklesekoppler verwendeten Optokopplers zur Spannungsstabilisierung im Rücklesepfad beitragen. Die Spannungsstabilisierung kann somit auf einfache Weise realisiert werden.

In einer weiteren Ausgestaltung kann das Sicherheitsschaltgerät ferner eine geregelte Strombegrenzung aufweisen, die durch die Abschalteinrichtung schaltbar in dem vierten Leitungspfad angeordnet ist, sowie einen durch den zweiten Rücklesekoppler gebildeten fünften Leitungspfad, der parallel zu dem zweiten Leitungspfad zwischen dem vierten Anschluss und dem zweiten Anschluss ausgebildet ist.

Bei dieser Ausgestaltung ist in dem schaltbaren Rücklesepfad eine Strombegrenzung vorgesehen. Die Strombegrenzung kann beispielsweise in Form einer Konstantstromquelle ausgebildet sein. Ähnlich wie die zuvor beschriebene Spannungsstabilisierung ermöglicht die Strombegrenzung eine Reduzierung der Abhängigkeit von der angeschlossenen Last bzw. den zu schaltenden Potentialen beim Rücklesen. Somit kann auch diese Auslegung zu einer Verbesserung der Rücklesefähigkeit und zu einer weiteren Erhöhung der Zuverlässigkeit der Rücklesung beitragen.

In einer weiteren Ausgestaltung kann das Sicherheitsschaltgerät ferner einen sechsten schaltbaren Leitungspfad zwischen dem ersten Anschluss und dem vierten Anschluss aufweisen. Dieser ermöglicht es, das Sicherheitsschaltgerät in einer ersten Betriebsart und in einer zweiten Betriebsart zu betreiben, wobei in der ersten Betriebsart über den ersten Leitungspfad das erste Potential auf den dritten Anschluss schaltbar ist und über den zweiten Leitungspfad das zweite Potential auf den vierten Anschluss schaltbar ist, und wobei in der zweiten Betriebsart über den ersten Leitungspfad das erste Potential auf den dritten Anschluss schaltbar ist und über den sechsten Leitungspfad das erste Potential auf den vierten Anschluss schaltbar ist.

Durch den umschaltbaren sechsten Leitungspfad kann das Sicherheitsschaltgerät auf zwei verschiedene Arten eingesetzt werden. Zum einen kann das Sicherheitsschaltgerät einen zweipoligen Ausgang bereitstellen, der es ermöglicht, eine zwischen die Anschlüsse des zweipoligen Ausgangs geschaltete Last an beiden Polen abzuschalten. Andererseits kann das Sicherheitsschaltgerät auch als Ausgangssignal-Schaltgerät (OSSD) betrieben werden. Jeder Anschluss bildet dann einen einzelnen einpoligen Ausgang, auf den jeweils das erste Potential geschaltet werden kann. Sowohl in der ersten als auch in der zweiten Betriebsart können die zuvor beschriebenen Verbesserungen hinsichtlich der Rücklesbarkeit realisiert werden. Zusätzlich erhöht sich die Einsatzmöglichkeit des Sicherheitsschaltgerätes, da verschiedene Anwendungsfälle mit einem einzelnen Gerät abgedeckt werden können.

In einer weiteren Ausgestaltung kann das Sicherheitsschaltgerät eine Umschalteinrichtung aufweisen, die zum Umschalten zwischen der ersten und der zweiten Betriebsart eingerichtet ist, wobei das Sicherheitsschaltgerät bestimmungsgemäß ausschließlich in der ersten oder der zweiten Betriebsart betreibbar ist, wobei in der ersten Betriebsart der dritte und der vierte Anschluss einen zweipoligen Ausgang zum Schalten eines einzelnen Verbrauchers bereitstellen, und wobei in der zweiten Betriebsart der dritte Anschluss einen ersten einpoligen Ausgang für einen ersten externen Verbraucher und der vierte Anschluss einen zweiten einpoligen Ausgang für einen zweiten externen Verbraucher bereitstellen.

Gemäß dieser Ausführungsform kann das Sicherheitsschaltgerät mittels einer Umschalteinrichtung zwischen der ersten und der zweiten Betriebsart umgeschaltet werden. Die Umschalteinrichtung kann als Schalter oder als Einstellparameter ausgebildet sein und beispielsweise durch einen Endnutzer selbst oder einen Installateur betätigt werden. Damit ist das Sicherheitsschaltgerät besonders flexibel einsetzbar.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert.
Fig. 1 zeigt eine vereinfachte, perspektivische Darstellung eines Sicherheitsschaltgeräts.
Fig. 2 zeigt ein vereinfachtes Schaltungsdiagramm eines Sicherheitsschaltgeräts mit einer Rückleseeinrichtung gemäß einer ersten Ausführungsform der vorliegenden Offenbarung.
Fig. 3 zeigt ein vereinfachtes Schaltungsdiagramm eines Sicherheitsschaltgeräts mit einer Rückleseeinrichtung gemäß einer zweiten Ausführungsform der vorliegenden Offenbarung.
Fig. 4 zeigt ein vereinfachtes Schaltungsdiagramm eines Sicherheitsschaltgeräts mit einer Rückleseeinrichtung gemäß einer dritten Ausführungsform der vorliegenden Offenbarung.
Fig. 5 zeigt ein vereinfachtes Schaltungsdiagramm eines Sicherheitsschaltgeräts gemäß Fig. 4 in einer weiteren Betriebsart.

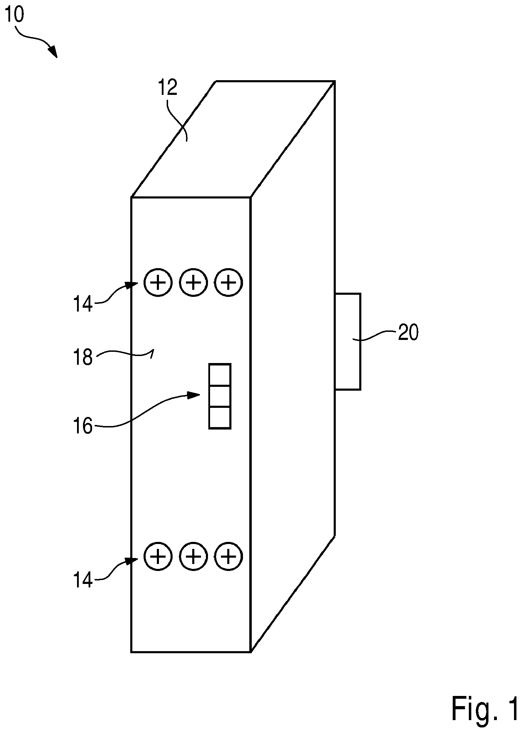

Fig. 1 zeigt eine vereinfachte, perspektivische Darstellung eines Sicherheitsschaltgerätes. Das Sicherheitsschaltgerät ist hier in seiner Gesamtheit mit Bezugsziffer 10 bezeichnet.

Ein Sicherheitsschaltgerät 10 im Sinne der vorliegenden Offenbarung ist eine Baugruppe mit einem Gehäuse 12 und einer darin angeordneten Elektronik. Die Elektronik ist dazu eingerichtet, auf Basis eines Eingangssignals einen Sicherheitskreis zu schließen. Mit anderen Worten schaltet ein Sicherheitsschaltgerät aufgrund eines Eingangssignals einen Leitungspfad zwischen einem Anschluss für ein Potential und einem Anschluss für ein Ausgangssignal leitend. Damit ermöglicht ein Sicherheitsschaltgerät z. B. die sichere Trennung eines externen Verbrauchers von einer Versorgungsspannung. Die Eingangssignale können von sogenannten Sicherheitsgebern wie z. B. Lichtschranken, Not-Aus-Tastern usw. geliefert werden, wenn diese einen sicheren Zustand signalisieren.

Die im Gehäuse 12 angeordnete Elektronik kann in Form von diskreten und integrierten elektrischen Bauelementen ausgeführt sein, die z. B. auf einer gemeinsamen Leiterplatte angeordnet sind. Über Anschlussklemmen 14, bspw. in Form von Schraub- oder Federklemmen an dem Gehäuse 12 des Sicherheitsschaltgeräts, ist die innen liegende Elektronik von außerhalb des Gehäuses 12 kontaktierbar. Über die Anschlussklemmen 14 kann z. B. ein externer Verbraucher an die Elektronik angeschlossen werden. Ebenso können Potentiale und Eingangssignale über die Anschlussklemmen 14 mit der Elektronik verbunden werden. Weitere Anschlussklemmen dienen als Ausgänge und ermöglichen die Ausgabe von Signalen oder Potentialen von der Elektronik. Die Anschlussklemmen 14 sind innerhalb des Gehäuses mit Anschlüssen der Elektronik verbunden.

Zusätzlich zu den Anschlussklemmen 14 können Anzeigeelemente 16 am Gehäuse 12 vorgesehen sein. Die Anzeigeelemente 16 können verschiedene Zustände des Sicherheitsschaltgeräts anzeigen und beispielsweise eine Power-LED, eine Schaltzustandsanzeige oder eine Fehleranzeige umfassen. Die Anschlussklemmen 14 und die Anzeigeelemente 16 sind üblicherweise an einer Frontseite 18 des Gehäuses 12 angeordnet, sodass eine Vielzahl solcher Schaltgeräte nebeneinander in einem Schaltschrank, beispielsweise auf einer Hutschiene 20, angeordnet werden kann. Selbstverständlich ist das Sicherheitsschaltgerät nicht auf diese spezielle Gehäuseform beschränkt.

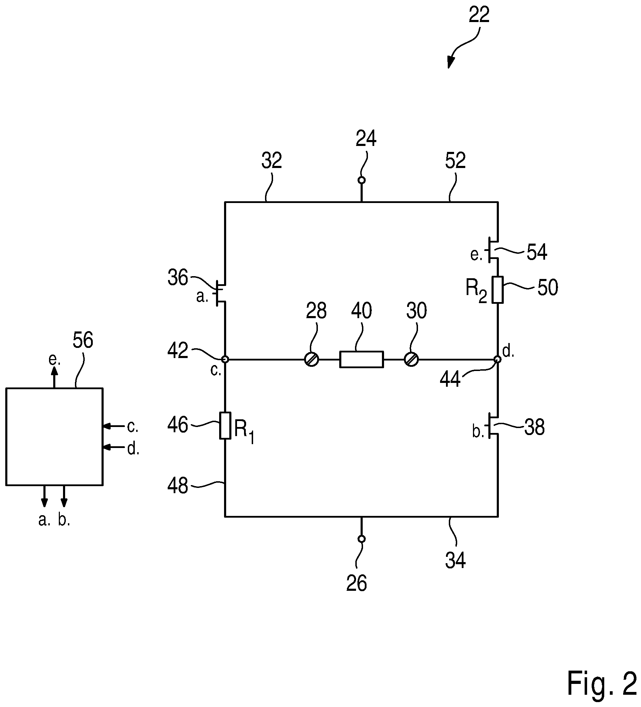

Fig. 2 zeigt ein vereinfachtes Schaltungsdiagramm eines Sicherheitsschaltgeräts mit einer Rückleseeinrichtung gemäß einer ersten Ausführungsform der vorliegenden Offenbarung.

Fig. 2 zeigt die Elektronik des Sicherheitsschaltgeräts 10 in stark vereinfachter Form und beschränkt sich auf die Darstellung der Leitungspfade zum Schalten von Potentialen an den Ausgängen sowie einer entsprechenden Rückleseeinrichtung, über die die Schaltzustände der Leitungspfade erfassbar sind. Selbstverständlich kann die Elektronik weitere Schaltungsteile und Bauelemente enthalten, die hier der Übersichtlichkeit halber weggelassen wurden.

Die Schaltung wird hier insgesamt mit der Bezugsziffer 22 bezeichnet. Die Schaltung 22 weist einen ersten Anschluss 24, einen zweiten Anschluss 26, einen dritten Anschluss 28 und einen vierten Anschluss 30 auf. Die ersten bis vierten Anschlüsse 24 bis 30 sind jeweils mit einer Anschlussklemme 14 an dem Gehäuse 12 des Sicherheitsschaltgeräts 10 verbindbar. Der erste und der zweite Anschluss 24, 26 sind jeweils mit einem externen Potential verbindbar. An den ersten Anschluss 24 kann ein erstes Potential angeschlossen werden, beispielsweise ein 24 V DC-Potential, wie es im industriellen Umfeld üblich ist. An den zweiten Anschluss 26 kann ein zweites Potential angeschlossen werden, das beispielsweise einem Massepotential entspricht. Vorzugsweise sind das erste und das zweite Potential Gegenpotentiale, die für den Betrieb eines externen Verbrauchers erforderlich sind. Selbstverständlich sind die Potentiale nicht auf die hier dargestellten Potentiale von 24 V und 0 V beschränkt.

Der externe Verbraucher, der mit den Potentialen betrieben werden soll, wird an die Anschlussklemmen 14 angeschlossen, die mit dem dritten Anschluss 28 und dem vierten Anschluss 30 verbunden sind. Über den dritten Anschluss 28 und den vierten Anschluss können die an dem ersten Anschluss 24 und dem zweiten Anschluss 26 anliegenden Potentiale ausgegeben werden. Dazu sind der erste Anschluss 24 und der dritte Anschluss 26 über einen ersten schaltbaren Leitungspfad 32 miteinander verbunden und der zweite Anschluss 26 und der vierte Anschluss 30 über einen zweiten schaltbaren Leitungspfad 34. Schaltbar bedeutet in diesem Zusammenhang, dass der Leitungspfad durch ein Schaltelement getrennt werden kann. Der erste und der zweite schaltbare Leitungspfad 32, 34 können sich somit entweder in einem leitenden Zustand oder in einem nicht leitenden Zustand befinden.

In dem ersten Leitungspfad 32 ist ein erstes Schaltelement 36 angeordnet und in dem zweiten Leitungspfad 34 ein zweites Schaltelement 38. Das erste Schaltelement 36 und das zweite Schaltelement 38 können jeweils Transistoren sein, beispielsweise Feldeffekttransistoren (FETs). Über die Schaltelemente 36, 38 können der erste Leitungspfad 32 und der zweite Leitungspfad 34 leitend geschaltet werden, sodass ein an dem ersten Anschluss 24 anliegendes Potential mit dem dritten Anschluss 28 und ein an dem zweiten Anschluss 26 anliegendes Signal mit dem vierten Anschluss 30 verbunden wird. Der dritte Anschluss 28 und der vierte Anschluss 30 werden aufgrund dieser Eigenschaft auch als schaltbare Ausgänge bezeichnet, da an ihnen jeweils ein Potential abgegriffen werden kann, um einen externen Verbraucher 40 zu betreiben. Bei dem externen Verbraucher 40 kann es sich beispielsweise um einen Antrieb handeln, der über die Anschlussklemmen 14, die den dritten Anschluss 28 und den vierten Anschluss 30 nach außen führen, angeschlossen ist. Der externe Verbraucher 40 kann neben einem Widerstand auch induktive und/oder kapazitive Eigenschaften aufweisen.

Die Schaltelemente 36, 38 werden in Abhängigkeit von einem dem Sicherheitsschaltgerät zugeführten Eingangssignal betätigt, sodass die Ausgänge in Abhängigkeit des Eingangssignals geschaltet werden. Aus Gründen der Übersichtlichkeit ist eine entsprechende Eingangsschaltung hier nicht dargestellt. Da auf den dritten Anschluss 28 und den vierten Anschluss 30 unterschiedliche Potentiale geschaltet werden können, werden die beiden Ausgänge zusammen als zweipoliger Ausgang bezeichnet. Mit dem Sicherheitsschaltgerät kann somit ein zweipoliger Verbraucher 40 an beiden Polen abgeschaltet werden, um den Verbraucher 40 sicher von den Versorgungspotentialen zu trennen.

Um sicherstellen zu können, dass sowohl das erste Schaltelement 36 als auch das zweite Schaltelement 38 korrekt schalten und der erste Leitungspfad 32 und der zweite Leitungspfad 34 entsprechend in einem leitenden bzw. nicht leitenden Zustand sind, sind in der Schaltung 22 Rückleseanschlüsse vorgesehen. Dem dritten Anschluss 28 ist ein erster Rückleseanschluss 42 und dem vierten Anschluss 30 ist ein zweiter Rückleseanschluss 44 zugeordnet. Die Rückleseanschlüsse 42, 44 befinden sich jeweils in den Leitungspfaden zwischen dem jeweiligen Schaltelement 36, 38 und dem Ausgangsanschluss (dritter und vierter Anschluss 28, 30).

An dem ersten Rückleseanschluss 42 ist ein an dem dritten Anschluss 28 anliegendes Potential und an dem zweiten Rückleseanschluss 44 ist ein an dem vierten Anschluss anliegendes Potential erfassbar. Durch die Erfassung der jeweils anliegenden Potentiale können neben einer Diagnose auch Schalttests durchgeführt werden, um die korrekte Funktion der Schaltelemente 36, 38 zu überprüfen. Bei Fehlverhalten, z.B. wenn bei einem Schalttest ein anliegendes Potential von einem Erwartungswert abweicht, können entsprechende Maßnahmen ergriffen werden, um den externen Verbraucher in einen sicheren Zustand zu überführen. Das Rücklesen der Ausgänge ist daher für eine ausreichende Sicherheit der Abschaltung durch die Schaltelemente 36, 38 unerlässlich, insbesondere dann, wenn für die Schaltelemente gewöhnliche Transistoren verwendet werden, die für sich genommen keine sicherheitsrelevanten Einrichtungen aufweisen, mit denen ein Schaltvorgang sicher gewährleistet werden kann.

Zum Rücklesen der Ausgänge können Rücklesekoppler in Form von Spannungsteilern oder Optokopplern verwendet werden, die jeweils zwischen den rückzulesenden Anschluss (dritter bzw. vierter Anschluss 28, 30) und das jeweilige Gegenpotential des Anschlusses (erster bzw. vierter Anschluss 24, 26) geschaltet werden. Für das Rücklesen über den ersten Rückleseanschluss 42 am dritten Anschluss 28 kann dementsprechend ein erster Spannungsteiler 46 (hier vereinfacht als Gesamtwiderstand dargestellt) zwischen dem dritten Anschluss 28 und dem zweiten Anschluss 26 vorgesehen sein, sodass ein dritter Leitungspfad 48 zwischen dem dritten Anschluss 28 und dem zweiten Anschluss 26 gebildet ist. Für das Rücklesen über den zweiten Rückleseanschluss 44 am vierten Anschluss 30 kann wiederum ein zweiter Spannungsteiler 50 (hier ebenfalls vereinfacht als ein Gesamtwiderstand dargestellt) zwischen dem vierten Anschluss 30 und dem ersten Anschluss 24 vorgesehen sein, sodass sich ein vierter Leitungspfad 52 zwischen dem vierten Anschluss 30 und dem ersten Anschluss 24 ergibt.

Durch den dritten Leitungspfad 48 und den vierten Leitungspfad 52 kann ein Strom zum ersten Anschluss 24 und zum zweiten Anschluss 26 fließen, auch wenn der erste Leitungspfad 32 bzw. der zweite Leitungspfad 34 unterbrochen ist. Diese Ströme können zu fehlerhaften Rücklesungen führen. So können z. B. bei einem Ausschalttest in dem zweiten Leitungspfad Pseudofehlern an dem ersten Rückleseanschluss auftreten und umgekehrt. Die beiden Ausgänge (dritter Anschluss 28 und vierter Anschluss 30) können sich somit beim Rücklesen gegenseitig stören.

Um diese Störungen beim Rücklesen reduzieren oder ausschließen zu können, sind in der vorliegenden Ausführungsform der dritte Leitungspfad 48 und der vierte Leitungspfad 52 modifiziert. So ist der vierte Leitungspfad 52 im Vergleich zu dem dritten Leitungspfad 48 einerseits niederohmiger ausgebildet und weist andererseits eine Abschalteinrichtung 54 auf, die den vierten Leitungspfad 52 zwischen einem leitenden und einem nicht leitenden Zustand umschalten kann.

In dem Ausführungsbeispiel gemäß Fig. 2 wird ein Widerstand des dritten Leitungspfads 48 im Wesentlichen durch einen Widerstand R1 eines ersten Rücklesekopplers, d.h. hier des Spannungsteilers 46, und ein Widerstand des vierten Leitungspfads 52 im Wesentlichen durch einen Widerstand R2 des zweiten Rücklesekopplers, d.h. hier des Spannungsteilers 50, bestimmt. Damit der vierte Leitungspfad 52 niederohmiger als der dritte Leitungspfad 48 ist, d.h. einen geringeren Widerstand als dieser aufweist, können die Rücklesekoppler derart ausgebildet sein, dass der Widerstand R2 kleiner als der Widerstand R1 ist (R2<R1).

Ferner ist der dritte Leitungspfad 52 mit einer Abschalteinrichtung 54 versehen, über die der vierte Leitungspfad 52 abgeschaltet werden kann. Die Abschalteinrichtung 54 kann ein weiteres Schaltelement sein, beispielsweise in Form eines Transistors. Mit der Abschalteinrichtung 54 kann ein Strom durch den vierten Leitungspfad 52 für eine bestimmte Zeitdauer unterbunden werden.

Die Abschalteinrichtung 54 kann durch eine hier nur schematisch dargestellte Testeinrichtung 56 betätigt werden. Die Kopplungen der Testeinrichtung 56 mit den Schaltungsteilen sind hier nur durch die Nummerierung a-e angedeutet. Die Testeinrichtung 56 kann direkt oder indirekt mit dem ersten Schaltelement 36 und dem zweiten Schaltelement 38 gekoppelt sein. Ferner kann die Testeinrichtung 56 mit den Rückleseklemmen 42, 44 gekoppelt sein, um den aktuellen Schaltzustand des ersten Schaltelements 36 und des zweiten Schaltelements 38 erfassen zu können. Ferner kann die Testeinrichtung 56 eingerichtet sein, die Abschalteinrichtung 54 zu betätigen. Die Testeinrichtung 56 führt ein Testprotokoll aus, um beispielsweise periodische Ausschalttests an dem ersten Schaltelement 36 und dem zweiten Schaltelement 38 durchzuführen und durch Rücklesen an den Rückleseanschlüssen die korrekte Funktion der Schaltelemente 36, 38 zu verifizieren.

Durch die genannten Anpassungen kann das Rücklesen der Ausgänge verbessert werden. So verhindert einerseits der hochohmige Rücklesepfad eine Störung des niederohmigen Rücklesepfades. Andererseits können durch die Abschalteinrichtung 54 des niederohmigen Rücklesepfads Pseudofehler im hochohmigen Rücklesepfad ausgeschlossen werden, indem der niederohmige Rücklesepfad während des Erfassungsvorgangs abgeschaltet wird. Da während der Trennung ein Rücklesen im getrennten Rücklesepfad nicht möglich ist, ist das Rücklesen im schaltbaren Rücklesepfad auf einen Zeitraum zu beschränken, in dem der niederohmige Rücklesepfad nicht durch die Abschalteinrichtung 54 getrennt ist. Dies kann durch ein entsprechendes Testprotokoll realisiert werden. Da die Trennung durch die Testeinrichtung 56 aktiv erfolgen kann, kann die Testeinrichtung 56 ohne weiteres auf den Zeitraum schließen, in dem ein Rücklesen im schaltbaren Rücklesepfad nicht möglich ist. Ein Rücklesen der Ausgänge kann somit kostengünstig und effektiv realisiert werden, wobei hierfür nur wenige bauliche Änderungen an der Rückleseschaltung erforderlich sind und auch ein entsprechendes Testprotokoll für das verbesserte Rücklesen einfach und ohne großen Aufwand realisiert werden kann.

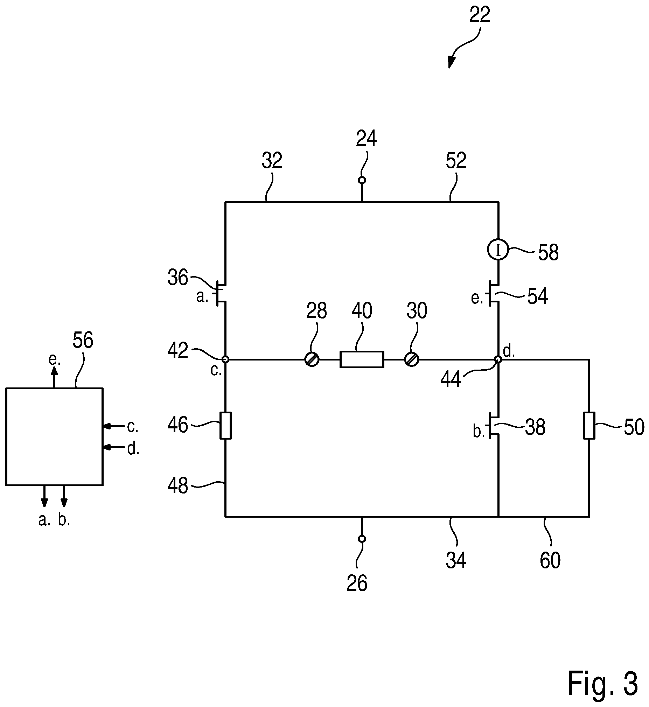

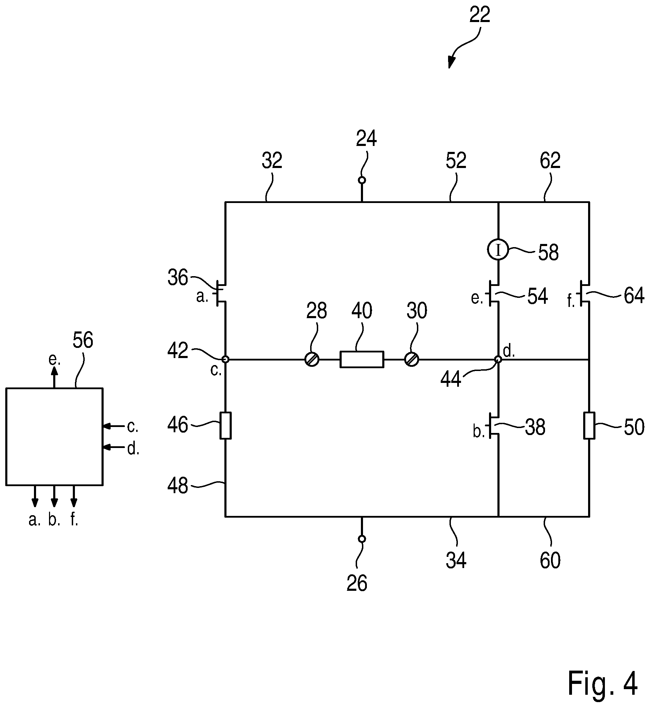

Unter Bezugnahme auf die Fig. 3 und 4 werden nachfolgend zwei weitere Ausführungsformen der in Fig. 2 gezeigten Schaltung 22 beschrieben, mit denen die gleichen Effekte wie oben beschrieben sowie weitere Effekte erzielt werden können. Bezugszeichen in den Fig. 3 und 4, die mit denen in Fig. 2 identisch sind, bezeichnen dabei gleiche oder ähnliche Teile wie in Fig. 2, und auf eine erneute Beschreibung dieser Teile wird im Folgenden verzichtet.

Die Schaltungsanordnung 22 gemäß Fig. 3 unterscheidet sich von der Schaltungsanordnung 22 gemäß Fig. 2 durch die Anordnung einer geregelten Strombegrenzung 58, beispielsweise in Form einer Konstantstromquelle, in dem vierten Leitungspfad 52. Konkret ist die geregelte Strombegrenzung 58 zwischen dem ersten Anschluss 24 und dem Schaltelement 54 angeordnet. Ferner ist der zweite Spannungsteiler 50 als Rücklesekoppler derart ausgebildet, dass er einen fünften Leitungspfad 60 zwischen dem vierten Anschluss 30 und dem zweiten Anschluss 26 bildet.

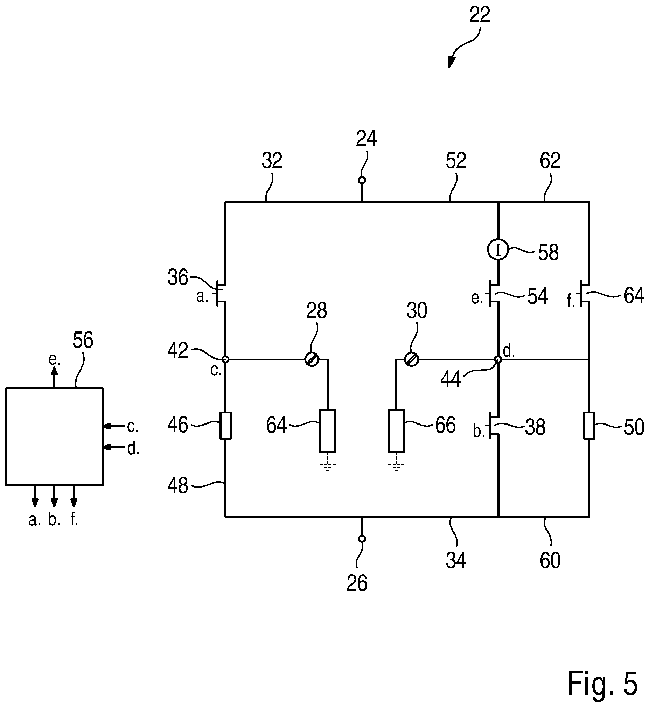

In der Ausführungsform gemäß Fig. 3 ist der schaltbare Rücklesepfad (vierter Leitungspfad 52) daher durch eine schaltbare Stromquelle gebildet. Auf diese Weise kann eine Abhängigkeit des Rücklesens am zweiten Rückleseanschluss von einer Höhe einer Versorgungsspannung (Potentialdifferenz zwischen dem ersten Anschluss 24 und dem zweiten Anschluss 26) vorteilhaft verringert werden. Ebenso kann durch diese Ausführungsform eine Abhängigkeit von den elektrischen Eigenschaften des angeschlossenen externen Verbrauchers verringert werden. Somit kann gemäß der Ausführungsform nach Fig. 3 eine Rücklesung weiter verbessert werden. Ferner muss bei der Ausgestaltung gemäß Fig. 3 der vierte Leitungspfad 52 nicht notwendigerweise niederohmig gegenüber dem dritten Leitungspfad 48 sein, wie dies beispielsweise bei der Ausgestaltung gemäß Fig. 2 angenommen wird, da hier die Rücklesung des zweiten Rücklesekopplers über 0V erfolgen kann. Dies gilt auch für die später beschriebene Ausgestaltung gemäß Fig. 4 und Fig. 5.

Alternativ zu der schaltbaren Stromquelle gemäß Fig. 3 ist es auch denkbar, eine Spannungsstabilisierung in dem abschaltbaren Rücklesepfad vorzusehen und als Rücklesekoppler einen Optokoppler zu verwenden, wobei sich eine LED des Optokopplers in dem Rücklesepfad befindet. Auf diese Weise kann ebenfalls die Abhängigkeit von der Versorgungsspannung bzw. von der externen Last vorteilhaft reduziert werden.

Fig. 4 und Fig. 5 zeigen eine weitere Ausführungsform, die auf der Ausführungsform gemäß Fig. 3 aufbaut. Die Rückleseeinrichtung gemäß Fig. 4 und Fig. 5 entspricht der Rückleseeinrichtung mit einer deaktivierbaren Stromquelle gemäß Fig. 3 und weist zusätzlich einen sechsten Leitungspfad 62 zwischen dem ersten Anschluss 24 und dem vierten Anschluss 30 auf. Über ein viertes Schaltelement 64 ist der sechste Leitungspfad 62 schaltbar.

Der zusätzliche sechste Leitungspfad 62 ermöglicht es, das erste Potential des ersten Anschlusses 24 alternativ an den vierten Anschluss 30 abzugeben. Auf diese Weise kann eine weitere Betriebsart des Sicherheitsschaltgeräts realisiert werden. So kann eine erste Betriebsart, wie mit Bezug auf die Fig. 2 und 3 beschrieben, realisiert werden, bei der der dritte Anschluss 28 und der vierte Anschluss 30 zusammen einen einzigen zweipoligen Ausgang für einen zwischengeschalteten Verbraucher bilden, dessen Pole jeweils trennbar sind.

Darüber hinaus kann, wie in Fig. 5 gezeigt, eine zweite Betriebsart realisiert werden, bei der der dritte Anschluss 28 und der vierte Anschluss 30 jeweils einen einzelnen einpoligen Ausgang bilden. Ein solcher Ausgang kann zum Schalten eines Verbrauchers gegen ein externes Potential verwendet werden. Das an dem ersten Anschluss 24 anliegende erste Potential, z.B. die oben genannten 24 V, kann über den dritten Anschluss 28 einem ersten externen Verbraucher 64 und über den vierten Anschluss 30 einem zweiten externen Verbraucher 66 zugeführt werden.

Die Rückleseanschlüsse 42, 44 können auch in der zweiten Betriebsart in gleicher Weise wie bei dem zweipoligen Ausgang verwendet werden, wobei in der zweiten Betriebsart an dem zweiten Rückleseanschluss ein Rücklesen in Bezug auf den sechsten Leitungspfad 62 und nicht in Bezug auf den zweiten Leitungspfad 34 erfolgt.

Die Ausführungsform gemäß Fig. 4 und Fig. 5 ermöglicht somit den wahlweisen Betrieb in einer ersten Betriebsart oder in einer zweiten Betriebsart. In der ersten Betriebsart kann ein externer Verbraucher, der zwischen dem dritten Anschluss 28 und dem vierten Anschluss 30 angeschlossen ist, an beiden Polen sicher abgeschaltet werden. In der zweiten Betriebsart können zwei Verbraucher, von denen einer an den dritten Anschluss 28 und einer an den vierten Anschluss 30 angeschlossen ist, jeweils an einem Pol sicher abgeschaltet werden. Letzteres ermöglicht den Einsatz als OSSD, wobei die geschalteten Potentiale den OSSD-Signalen entsprechen.

In beiden Betriebsarten kann eine sichere Trennung über die Rückleseanschlüsse 42, 44 gewährleistet werden, wobei eine Rücklesung an dem zweiten Rückleseanschluss 44 entsprechend der Betriebsart zu interpretieren ist.

Die Ausführungsform nach den Figuren 4 und 5 verbessert somit das Sicherheitsschaltgerät dahingehend, dass neben der verbesserten Rücklesbarkeit die Einsatzmöglichkeiten erweitert werden und ein einziges Gerät für verschiedene Anwendungen eingesetzt werden kann.

Es versteht sich von selbst, dass dem Fachmann weitere Varianten einfallen, mit denen die beschriebene Idee verwirklicht werden kann. Beispielsweise kann bei der Ausgestaltung nach den Figuren 4 und 5 anstelle der abschaltbaren Stromquelle auch eine Variante mit einer Spannungsstabilisierung und einem Optokoppler als Rücklesekoppler verwendet werden. Grundsätzlich können in allen dargestellten Beispielen die Rücklesekoppler jeweils durch Optokoppler anstelle eines Spannungsteilers realisiert werden. Ebenso sind die Schaltelemente zum Schalten der Potentiale an den Ausgängen nicht auf Halbleiter beschränkt, sondern können auch anders realisiert werden, z. B. durch Relais oder ähnliche elektronische oder elektromechanische Schalter.

Es wird darauf hingewiesen, dass die vorstehenden Ausführungsbeispiele nur exemplarisch sind und weitere Varianten einzelner Komponenten möglich sind, um Ausgestaltungen der nachfolgenden Ansprüche zu realisieren. Der Schutzumfang der vorliegenden Erfindung wird durch die nachfolgenden Ansprüche bestimmt und ist nicht durch die in der Beschreibung erläuterten oder in den Figuren dargestellten Merkmale begrenzt.

## Patentansprüche

1. Sicherheitsschaltgerät (10) zur fehlersicheren Abschaltung eines externen Verbrauchers (40), aufweisend:
einen ersten Anschluss (24) zum Aufnehmen eines ersten Potentials;
einen zweiten Anschluss (26) zum Aufnehmen eines zweiten Potentials;
einen dritten Anschluss (28) zum Ausgeben des ersten Potentials an den externen Verbraucher (40);
einen vierten Anschluss (30) zum Ausgeben des zweiten Potentials an den externen Verbraucher (40);
einen ersten schaltbaren Leitungspfad (32) zwischen dem ersten Anschluss (24) und dem dritten Anschluss (28), der in einem eingeschalteten Zustand das erste Potential mit dem dritten Anschluss (28) verbindet;
einen zweiten schaltbaren Leitungspfad (34) zwischen dem zweiten Anschluss (26) und dem vierten Anschluss (30), der in einem eingeschalteten Zustand das zweite Potential mit dem vierten Anschluss (30) verbindet;
einen ersten Rücklesekoppler, über den ein an dem dritten Anschluss (28) anliegendes erstes Rücklesepotential erfassbar ist;
einen zweiten Rücklesekoppler, über den ein an dem vierten Anschluss (30) anliegendes zweites Rücklesepotential erfassbar ist;
einen durch den ersten Rücklesekoppler gebildeten dritten Leitungspfad (48) zwischen dem zweiten Anschluss (26) und dem dritten Anschluss (28); sowie
einen vierten Leitungspfad (52) zwischen dem ersten Anschluss (24) und dem vierten Anschluss (30), der mit dem zweiten Rücklesekoppler verbunden ist,
wobei der vierte Leitungspfad (52) eine Abschalteinrichtung (54) aufweist, über die der vierte Leitungspfad (52) zwischen einem leitenden Zustand und einem nicht leitenden Zustand umschaltbar ist.

2. Sicherheitsschaltgerät nach Anspruch 1, wobei der vierte Leitungspfad (52) niederohmiger ausgebildet ist als der dritte Leistungspfad (48)

3. Sicherheitsschaltgerät nach Anspruch 1 oder 2, wobei der erste Rücklesekoppler und/oder der zweite Rücklesekoppler ein Spannungsteiler (46, 50) ist.

4. Sicherheitsschaltgerät nach Anspruch 1 oder 2, wobei der erste Rücklesekoppler und/oder der zweite Rücklesekoppler ein Optokoppler ist.

5. Sicherheitsschaltgerät nach einem der Ansprüche 1 bis 4, ferner aufweisend: eine Testeinrichtung (56), die mit dem ersten Rücklesekoppler und dem zweiten Rücklesekoppler verbunden ist und dazu eingerichtet ist, über den ersten Rücklesekoppler das erste Rücklesepotential zu erfassen und über den zweiten Rücklesekoppler das zweite Rücklesepotential zu erfassen sowie anhand des ersten Rücklesepotentials einen Schaltzustand des ersten Leitungspfads (32) zu bestimmen und anhand des zweiten Rücklesepotentials einen Schaltzustand des zweiten Leitungspfads (34) zu bestimmen.

6. Sicherheitsschaltgerät nach Anspruch 5, wobei die Abschalteinrichtung (54) in dem vierten Leitungspfad (52) von der Testeinrichtung (56) ansteuerbar ist, um den vierten Leistungspfad (52) leitend oder nicht leitend zu schalten.

7. Sicherheitsschaltgerät nach Anspruch 5 oder 6, wobei die Testeinrichtung (56) dazu eingerichtet ist, den Schaltzustand des zweiten Leitungspfads (34) nur dann zu bestimmen, wenn der vierte Leitungspfad (52) in dem leitenden Zustand ist.

8. Sicherheitsschaltgerät nach einem der Ansprüche 5 bis 7, wobei die Testeinrichtung (56) eingerichtet ist, den Schaltzustand des ersten Leitungspfads (48) nur dann zu bestimmen, wenn der vierte Leitungspfad (52) in dem nicht leitenden Zustand ist.

9. Sicherheitsschaltgerät nach einem der Ansprüche 1 bis 8, wobei die Abschalteinrichtung (54) ein Transistor ist, insbesondere ein Feldeffekttransistor.

10. Sicherheitsschaltgerät nach einem der Ansprüche 1 bis 9, ferner aufweisend: eine Spannungsstabilisierung, die durch die Abschalteinrichtung (54) schaltbar in dem vierten Leitungspfad (52) angeordnet ist.

11. Sicherheitsschaltgerät nach Anspruch 10, wobei der zweite Rücklesekoppler als ein Optokoppler ausgebildet ist, insbesondere mit einer Leuchtdiode, die in dem vierten Leitungspfad (52) angeordnet ist.

12. Sicherheitsschaltgerät nach einem der Ansprüche 1 bis 11, ferner aufweisend: eine geregelte Strombegrenzung (58), die durch die Abschalteinrichtung (54) schaltbar in dem vierten Leitungspfad (52) angeordnet ist; sowie einen durch den zweiten Rücklesekoppler gebildeten fünften Leitungspfad (60), der parallel zu dem zweiten Leitungspfad (34) zwischen dem zweiten Anschluss (26) und dem vierten Anschluss (30) ausgebildet ist.

13. Sicherheitsschaltgerät nach einem der Ansprüche 1 bis 12, ferner aufweisend: einen sechsten schaltbaren Leitungspfad (62) zwischen dem ersten Anschluss (24) und dem vierten Anschluss (30).

14. Sicherheitsschaltgerät nach Anspruch 13, wobei das Sicherheitsschaltgerät (10) in einer ersten Betriebsart und in einer zweiten Betriebsart betreibbar ist, wobei in der ersten Betriebsart das erste Potential an den dritten Anschluss (28) über den ersten Leitungspfad (32) schaltbar ist und das zweite Potential über den zweiten Leitungspfad (34) an den vierten Anschluss (30) schaltbar ist, und wobei in der zweiten Betriebsart das erste Potential an den dritten Anschluss (28) über den ersten Leitungspfad (32) schaltbar ist und das erste Potential über den sechsten Leitungspfad (62) an den vierten Anschluss (30) schaltbar ist.

15. Sicherheitsschaltgerät nach Anspruch 14, wobei das Sicherheitsschaltgerät (10) eine Umschalteinrichtung aufweist, die dazu eingerichtet ist, zwischen der ersten Betriebsart und der zweiten Betriebsart umzuschalten, wobei das Sicherheitsschaltgerät (10) bestimmungsgemäß ausschließlich in der ersten Betriebsart oder der zweiten Betriebsart betreibbar ist, wobei in der ersten Betriebsart der dritte Anschluss (28) und der vierte Anschluss (30) einen zweipoligen Ausgang zum Schalten eines einzelnen Verbrauchers (40) bereitstellen, und wobei in der zweiten Betriebsart der dritte Anschluss (28) einen ersten einpoligen Ausgang für einen ersten externen Verbraucher (64) und der vierte Anschluss (30) einen zweiten einpoligen Ausgang für einen zweiten externen Verbraucher (66) bereitstellen.
